(19) Europäisches Patentamt

European Patent Office

Office européen des brevets

(11) **EP 1 620 904 B1**

(12) **FASCICULE DE BREVET EUROPEEN**

(45) Date de publication et mention
de la délivrance du brevet:
**06.09.2006 Bulletin 2006/36**

(21) Numéro de dépôt: **04742607.7**

(22) Date de dépôt: **29.04.2004**

(51) Int Cl.:
*H01L 41/107* (2006.01)    *H03K 17/689* (2006.01)
*H03K 17/605* (2006.01)

(86) Numéro de dépôt international:
**PCT/FR2004/001041**

(87) Numéro de publication internationale:
**WO 2004/102688 (25.11.2004 Gazette 2004/48)**

(54) **CIRCUIT ELECTRONIQUE A TRANSFORMATEUR PIEZO-ELECTRIQUE INTEGRE**

ELEKTRONISCHE SCHALTUNG MIT INTEGRIERTEM PIEZOELEKTRISCHEN TRANSFORMATOR

ELECTRONIC CIRCUIT COMPRISING EMBEDDED PIEZOELECTRIC TRANSFORMER

(84) Etats contractants désignés:
**AT BE BG CH CY CZ DE DK EE ES FI FR GB GR
HU IE IT LI LU MC NL PL PT RO SE SI SK TR**

(30) Priorité: **07.05.2003 FR 0305601**

(43) Date de publication de la demande:
**01.02.2006 Bulletin 2006/05**

(73) Titulaires:
• **CENTRE NATIONAL DE
LA RECHERCHE SCIENTIFIQUE (CNRS)
75794 Paris Cedex 16 (FR)**
• **ECOLE NORMALE SUPERIEURE DE CACHAN
94235 Cachan (FR)**

(72) Inventeurs:
• **COSTA, François
F-94230 Cachan (FR)**
• **VASIC, Dejan
F-75010 Paris (FR)**
• **SARRAUTE, Emmanuel
F-77420 Champs Sur Marne (FR)**

(74) Mandataire: **Burbaud, Eric et al
Cabinet Plasseraud
65/67 rue de la Victoire
75440 Paris Cedex 09 (FR)**

(56) Documents cités:
**EP-A- 0 689 254**

• **VASIC D ET AL: "A new MOSFET & IGBT gate
drive insulated by a piezoelectric transformer"
2001 IEEE 32ND ANNUAL POWER
ELECTRONICS SPECIALISTS CONFERENCE,
VANCOUVER, CANADA, 17 juin 2001
(2001-06-17), - 21 juin 2001 (2001-06-21) pages
1479-1484, XP001054278 ISBN: 0-7803-7067-8**

EP 1 620 904 B1

**Description**

La présente invention est relative aux circuits électroniques, notamment aux circuits électroniques pour la commande de composants électroniques de puissance.

Plus particulièrement, l'invention concerne un circuit électronique muni d'un transformateur piézo-électrique destiné à commander un composant électronique, dans lequel le transformateur comprend une armature primaire et une armature secondaire, constituées à partir d'un matériau piézo-électrique, et une couche intermédiaire isolante, intercalée entre les armatures primaire et secondaire, l'armature primaire étant agencée pour transmettre, en réponse à un signal primaire transmis à l'armature primaire via le circuit électronique, un signal moteur à l'armature secondaire, à travers la couche intermédiaire, l'armature secondaire délivrant au composant électronique un signal secondaire, fonction du signal primaire, pour commander le composant électronique auquel l'armature secondaire est connectée comme décrtit dans le document EP 0689254.

Il est proposé par les inventeurs, dans l'article « Commande de transistor à grille isolée par transformateur piézo-électrique », Congrès EPF 2002, Montpellier, France, Novembre 2002 et l'article «A new HOSFET & IGBT gate drive insulated by a piezoelectric transformer», 32nd Annual Power Electronics Specialists Conference, Vancouver, Canada, juin 2001, XP1054278, d'utiliser un tel circuit électronique comprenant un transformateur piézo-électrique multicouche, dont les armatures primaire et secondaire sont formées chacune d'une couche de matériau piézoélectrique munie de ses électrodes, pour réaliser une fonction de commande rapprochée d'un transistor de puissance à grille isolée. Dans ce circuit, le transformateur a pour but d'assurer la transmission des ordres de commande de façon très fiable et avec une excellente isolation galvanique.

La présente invention a notamment pour but de perfectionner ce type de circuit, notamment en proposant une forme concrète d'intégration du transformateur piézo-électrique au circuit électronique comportant le composant électronique à commander.

A cet effet, selon l'invention, on prévoit un circuit électronique qui, outre les caractéristiques précédentes, est caractérisé en ce qu'il comporte une première couche dans laquelle est intégrée l'armature primaire et une deuxième couche dans laquelle est intégrée l'armature secondaire, les première et deuxième couches étant galvaniquement isolées par la couche intermédiaire.

Grâce à ces dispositions, les armatures primaire et secondaire du transformateur piézo-électrique sont respectivement dans les première et deuxième couches pouvant, par exemple, elles-mêmes constituer respectivement des circuits électroniques primaire et secondaire du transformateur.

Dans des modes de réalisation préférés de l'invention, on peut éventuellement avoir recours en outre à l'une et/ou à l'autre des dispositions suivantes :

- les première et deuxième couches sont constituées d'un substrat de matériau choisi parmi du circuit imprimé, de la céramique et du semi-conducteur, et supportent chacune une face de circuit imprimé, les armatures primaire et secondaire étant fixées dans des évidements préalablement ménagés respectivement dans chacune des couches ;
- au moins une couche conductrice est intercalée entre les première et deuxième couches ;
- le composant électronique est un transistor de puissance intégré à la deuxième couche et comportant une grille recevant le signal secondaire
- la première couche comporte un circuit primaire comprenant un modulateur connecté à l'armature primaire, et adapté pour former le signal primaire avec une modulation d'au moins un signal porteur par un signal de commande, et pour délivrer à l'armature primaire le signal primaire ainsi formé, et la deuxième couche comporte un circuit secondaire comprenant un démodulateur, connecté entre l'armature secondaire et le composant électronique, et adapté pour transmettre à ce composant électronique un signal démodulé à partir du signal secondaire correspondant au signal de commande (la modulation du signal porteur par le signal de commande peut être une modulation d'amplitude ou de fréquence) ;
- le circuit secondaire comprend en outre un dispositif de redressement, connecté entre l'armature secondaire et le démodulateur, et adapté pour redresser le signal secondaire délivré par l'armature secondaire ;
- le circuit secondaire comprend en outre un dispositif de verrouillage connecté entre le démodulateur et le composant électronique, et adapté pour délivrer au composant électronique un signal démodulé fiabilisé ;
- le circuit électronique comprend un oscillateur adapté pour délivrer au modulateur le signal porteur à une fréquence proche d'une fréquence de résonance mécanique du transformateur ;
- l'oscillateur est adapté pour délivrer un signal porteur à une fréquence proche de la fréquence du deuxième mode propre de vibration du transformateur ;
- les armatures primaire et secondaire sont formées à partir d'un matériau piézo-électrique polarisé selon l'épaisseur ;
- le composant électronique est un transistor MOSFET ou IGBT ;
- le circuit électronique comprend en outre une armature primaire piézo-électrique supplémentaire intégrée à la première couche et une armature secondaire piézo-électrique supplémentaire intégrée à la deuxième couche reliée à un composant électronique supplémentaire, les composants électroniques étant connectés pour réaliser un bras de pont complet.

D'autres caractéristiques et avantages de l'invention apparaîtront au cours de la description suivante d'une de ses formes de réalisation, donnée à titre d'exemple non limitatif, en regard des dessins joints.

Sur les dessins :

- la figure 1 est une coupe schématique d'un exemple de circuit électronique imprimé de commande, conforme à l'invention et intégrant un transformateur piézo-électrique,
- la figure 2 est une vue schématique du mode de vibrations dans l'épaisseur du transformateur piézo-électrique du circuit électronique de la figure 1,
- la figure 3 représente schématiquement en perspective un transformateur piézo-électrique, tel que celui intégré au circuit de la figure 1,
- la figure 4 représente un schéma électrique simplifié du transformateur représenté sur la figure 3,
- la figure 5 représente le schéma électrique du circuit de la figure 1, et
- la figure 6 représente un autre exemple de circuit de commande rapprochée de grille de transistor, selon l'invention.

Sur les différentes figures, les mêmes références désignent des éléments identiques ou similaires.

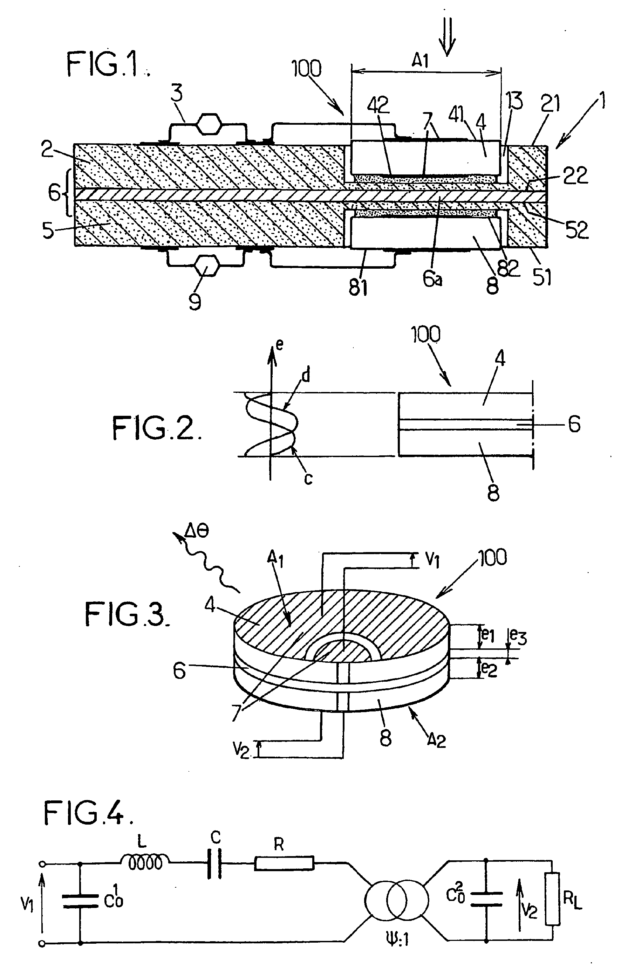

La figure 1 représente un exemple de circuit électronique 1 selon l'invention. Selon cet exemple, il s'agit d'un circuit imprimé 1, par exemple à base d'un substrat isolant en époxy, alumine, ou autre. Il comporte une première couche 2, et une deuxième couche 5. Les première 2 et deuxième 5 couches portent chacune une face de circuit imprimé tournée vers l'extérieur. Sur l'une 21 des faces est réalisé un circuit électronique primaire, sur l'autre 51 est réalisé un circuit électronique secondaire. Ces deux circuits primaire et secondaire sont isolés, électriquement par une couche intermédiaire 6 constituée par une plus ou moins grande épaisseur du matériau constitutif des première 2 et deuxième 5 couches.

Entre les première 2 et deuxième 5 couches est en outre, selon l'exemple de mode de réalisation présenté ici, insérée une couche conductrice 6a. Cette couche conductrice 6a réalise un écran électrostatique entre les première 2 et deuxième 5 couches.

Les circuits primaire et secondaire portent un ou plusieurs composants électroniques primaire 3 et secondaire 9.

Les première 2 et deuxième 5 couches ont une épaisseur comprise entre environ 0,5 mm et 2 mm. Ces première 2 et deuxième 5 couches présentent chacune un évidement 13 préalablement ménagé, dans lequel est fixée une armature primaire 4 ou secondaire 8.

Ces armatures primaire 4 et secondaire 8 sont constituées par exemple de Zircono-titanate de Plomb (PZT) et présentent une forme cylindrique ou parallélépipédique globalement plane, par exemple, avec une surface $A_1$, $A_2$ et une épaisseur $e_1$, $e_2$ proche de l'épaisseur de la première couche 2, de la deuxième couche 5, respectivement.

Les surfaces respectives $A_1$ et $A_2$ des armatures primaire 4 et secondaire 8 sont sensiblement égales. Par contre, les épaisseurs respectives $e_1$ et $e_2$ des armatures primaire 4 et secondaire 8 peuvent être différentes.

Les armatures primaire 4 et secondaire 8 comportent une face interne 42, 82 tournée vers l'autre armature, lorsque celles-ci sont en place dans leurs évidements 13 respectifs. De même, les armatures primaire 4 et secondaire 8 comportent une face externe 41, 81 opposée aux faces internes 42, 82 et affleurant sensiblement au niveau des circuits respectivement primaire et secondaire du circuit électronique 1. Les armatures primaire 4 et secondaire 8 sont ainsi placées de façon à ce que, lorsque visualisées selon une direction normale aux faces primaire et secondaire du circuit électronique 1 (par exemple dans le sens de la double flèche sur la figure 1), les armatures primaire 4 et secondaire 8 se superposent sensiblement.

Les armatures primaire 4 et secondaire 8 sont en outre recouvertes, sur au moins une partie de chacune de leurs faces interne 42, 82 et externe 41, 81 d'une métallisation 7 permettant d'y apposer des contacts électriques.

La fixation des armatures primaire 4 et secondaire 8 dans leurs évidements 13 se fait par exemple par cofrittage en plaçant dans le moule de fabrication du circuit une poudre piézoélectrique, la couche isolante et les métallisations, et en mettant sous presse.

La fixation peut également se faire par collage de la face interne 42, 82 d'armatures réalisées séparément sur le substrat époxy respectivement des première 2 et deuxième 5 couches. Pour réaliser le collage, on pourra préférentiellement utiliser une colle ayant des propriétés thermiques et mécaniques appropriées à ce type d'application, à savoir des propriétés de résistance thermique à l'échauffement, une grande dureté et une bonne tenue en tension. Il s'agit par exemple d'une colle époxy. L'armature est en outre polarisée de façon à vibrer dans son épaisseur lorsqu'elle est soumise à un courant électrique alternatif.

Les armatures primaire 4 et secondaire 8 sont distantes d'environ 0,1 à 1 mm. Entre elles, se trouve la couche intermédiaire 6, avec sa couche conductrice 6a enterrée.

La couche conductrice 6a est par exemple constituée de cuivre ou de tout autre matériau permettant de réaliser un écran électrostatique.

Les armatures primaire 4 et secondaire 8 ainsi intégrées dans un circuit imprimé et séparées par un écran électrostatique constituent un transformateur 100 piézo-électrique intégré.

Le transfert de puissance fourni par ce transformateur 100 s'effectue en transformant tout d'abord au niveau de l'armature primaire 4 de l'énergie électrique en vibrations mécaniques dans l'épaisseur de l'armature primaire 4. Cette vibration mécanique engendre la vibration du ou des matériau (x) intercalé(s) entre les armatures primaire 4 et secondaire 8, et de l'armature secondaire 8. On récupère au niveau de l'armature secondaire 8 ces vibrations sous forme d'énergie électrique. En conséquence, il n'y a aucun couplage électromagnétique dans ce type de transformateur, ce qui est favorable, en termes de normes de compatibilité électromagnétique.

Un tel transformateur 100 intégré peut être utilisé pour mettre en oeuvre, avec une excellente isolation galvanique, une fonction de commande rapprochée de transistor de puissance, tel un transistor MOSFET, un transistor IGBT, ou tout autre semi conducteur de puissance.

On utilise par exemple un transformateur 100 dont les armatures primaire 4 et secondaire 8 sont identiques en matériau, surface et épaisseur, et sont polarisées dans l'épaisseur, tel que représenté schématiquement sur la droite de la figure 2.

On excite ce transformateur 100 à une fréquence correspondant à son deuxième mode de vibration. On obtient alors les variations de contraintes (c) et de déplacement (d) le long de l'épaisseur représentées sur la gauche de la figure 2. Avec ce deuxième mode de vibration, les contraintes sont faibles dans la couche intermédiaire 6 sur laquelle sont collées les armatures primaire 4 et secondaire 8, ce qui est bénéfique au plan des risques de décollement. Par contre, la couche intermédiaire 6 subit un déplacement maximal.

On peut adapter le mode de vibrations à la géométrie dans l'épaisseur du transformateur afin de respecter cette condition de faibles contraintes dans la région où les collages sont effectués. Cette adaptation peut être souhaitable notamment lorsque les armatures primaire 4 et secondaire 8 n'ont pas des épaisseurs $e_1$ et $e_2$ identiques. On n'est cependant pas tenu de respecter à tout prix cette condition, par exemple si la résistance du collage est suffisante.

Les performances et caractéristiques techniques d'un tel transformateur 100 sont fortement liées aux caractéristiques mécaniques et physiques du type de matériau utilisé, et aux dimensions des éléments constitutifs du transformateur 100.

Si on a une connaissance a priori du type d'application pour lesquelles le transformateur 100 est susceptible d'être employé, on peut dimensionner celui-ci en fonction.

Comme représenté sur la figure 3, une tension $V_1$ est appliquée à l'armature primaire 4 du transformateur 100 (représenté de manière purement illustrative comme cylindrique), de dimensions $e_1$ et $A_1$, et une tension $V_2$ est obtenue au niveau de l'armature secondaire 8, de dimensions $e_2$ et $A_2$. On peut ou non tenir compte de la couche intermédiaire, d'épaisseur $e_3$, de superficie $A_3$ lors du dimensionnement.

Au cours d'un fonctionnement dans ces conditions, les pertes mécaniques dans le transformateur 100 se traduisent par un dégagement de chaleur $\Delta\theta$, qu'il peut être utile de maîtriser pour le bon fonctionnement de l'ensemble du circuit électronique 1. Pour y parvenir, il est possible d'appliquer la modélisation suivante.

On utilise le schéma électrique de la figure 4 qui est équivalent au transformateur 100 dans ses modes de résonance, comme décrit dans « Piezoelectric transformer operating in thickness extensional vibration and its application to switching converter », PESC 94, Zaitsu et al. Dans ce schéma, les valeurs des inductances L, résistances R, et capacités C, $C^1_0$ et $C^2_0$ sont liées aux caractéristiques physiques et mécaniques du transformateur 100. La résistance $R_L$ désigne quant à elle la résistance de charge du transformateur 100. Pour simplifier, les détails du dimensionnement sont donnés pour deux armatures primaire 4 et secondaire 8 dont les matériaux sont identiques, mais peuvent être facilement transposables à des armatures primaire 4 et secondaire 8 dont les matériaux sont différents.

Géométriquement, chaque armature 4 ou 8 est caractérisée par son épaisseur $e_1$, $e_2$ et son aire $A_1$, $A_2$. Le matériau est physiquement caractérisé par son module d'élasticité dans l'épaisseur $C_{33}^D$, sa permittivité $\varepsilon_{33}^S$, son coefficient piézo-électrique $e_{33}$, sa densité $\rho$, son facteur de qualité mécanique $Q_m$, un coefficient de convection au sein du matériau $h_c$, et un coefficient de couplage électromécanique $k_t$.

Dans un modèle de Mason, le couplage entre les caractéristiques géométriques et physiques de chaque armature est représenté par un transformateur parfait, dont le gain $\psi_1$ $\psi_2$ s'exprime par exemple par

$$\Psi_1 = \frac{A_1}{e_1} e_{33} \;.$$ Dans le modèle présenté, ces deux transformateurs parfaits sont regroupés en un seul, désigné par $\psi$.

Pour un tel transformateur, les caractéristiques mécaniques et physiques peuvent être reliées aux propriétés électriques du circuit équivalent de la figure 4 par les équations suivantes :

$$C^1_0 = \varepsilon_{33}{}^S * A_1 / e_1, \quad C^2_0 = \varepsilon_{33}{}^S * A_2 / e_2,$$

$$L = (e_1 + e_2 + e_3) \, e_1{}^2 \, \rho / 8 \, A_1 \, e^2{}_{33}$$

$$C = A_1 \, e^2{}_{33} / \pi^2 \, e_1 \, c_{33}{}^D,$$

$$R = [1 / Q_m] * (L / C)^{1/2},$$

et

$$\Psi = A_1 \, e_2 / A_2 \, e_1.$$

Par la suite, on s'intéresse de manière purement illustrative à un transformateur dont les deux armatures possèdent la même superficie A ($A_1 = A_2 = A$) et dont les épaisseurs $e_1$, $e_2$ sont grandes devant l'épaisseur $e_3$ de la couche intermédiaire ($e_1 + e_2 + e_3 \approx e_1 + e_2$), mais on peut tout à fait effectuer les opérations ci-dessous dans un exemple général.

En court-circuit, le transformateur présente une pulsation propre $\omega_S = 1 / (L\,C)^{1/2}$.

Pour prendre en compte l'état de charge du transformateur, on peut introduire un facteur de qualité électrique Q dépendant de la résistance de charge $R_L$ équivalente du circuit auquel la puissance est à transmettre :

$$Q = 1 / R_L \, C^2_0 \, \omega_S.$$

On peut également introduire un rapport c représentant la fraction d'énergie mécanique convertible en énergie électrique au secondaire :

$$c = \Psi^2 \, C^2_0 / C = (\pi^2/2k_t{}^2) \, (e_2/(e_1+e_2)) - (e_1+e_2)/e_2.$$

On peut estimer une pulsation $\omega_R$ de résonance du circuit entier prenant en compte la résistance de charge, par l'expression suivante liant $\omega_R$, c et $\omega_S$ :

$$\frac{\omega_R^2}{\omega_S^2} = \frac{1}{2}\left(1 + \frac{1}{c} - Q^2\right) + \sqrt{\frac{1}{4}\left(1 + \frac{1}{c} - Q^2\right)^2 + Q^2}\;.$$

En fonction de ces différents paramètres du circuit, et de la tension $V_1$ et la pulsation $\omega_R$ d'utilisation, on peut exprimer la puissance transmise $P_2$, le gain G et le rendement $\eta$ du transformateur 100 comme suit :

$$G = \frac{V_2}{V_1} = \frac{\psi}{\sqrt{\left[1 - c\left(\dfrac{\omega_R^2}{\omega_S^2} - 1 + \dfrac{Q}{Q_m}\right)\right]^2 + \left[\dfrac{c}{Q_m}\dfrac{\omega_R}{\omega_S} + cQ\left(\dfrac{\omega_R}{\omega_S} - \dfrac{\omega_S}{\omega_R}\right)\right]^2}}\;,$$

$$P_2 = \cfrac{\dfrac{V_1^2}{R} c \dfrac{Q}{Q_m}}{\left[1 - c\left(\dfrac{\omega_R^2}{\omega_S^2} - 1 + \dfrac{Q}{Q_m}\right)\right]^2 + \left[\dfrac{c}{Q_m}\dfrac{\omega_R}{\omega_S} + cQ\left(\dfrac{\omega_R}{\omega_S} - \dfrac{\omega_S}{\omega_R}\right)\right]^2},$$

et

$$\eta = \cfrac{1}{1 + \dfrac{Q}{Q_m} c\left(1 + \dfrac{1}{Q^2}\dfrac{\omega_R^2}{\omega_S^2}\right)}.$$

Les différentes sources de pertes sont à l'origine d'un échauffement de la structure. Or les propriétés du matériau piézoélectrique sont sensibles à la température du milieu. On peut donc vouloir dimensionner un transformateur dont l'échauffement au cours du fonctionnement sera inférieur à une valeur $\Delta\theta$ prédéfinie. Les pertes par échauffement s'écrivant $h_c$ S $\Delta\theta$, où S est la surface d'échange avec l'extérieur (S = 2A = $A_1$ + $A_2$ pour un transformateur de faible épaisseur), l'échauffement ne dépasse pas $\Delta\theta$ si la condition suivante est respectée :

$$P_2 \ (1-\eta)/\eta \ < \ h_c \ S \ \Delta\theta.$$

En remplaçant $\eta$ par l'expression ci-dessus, on obtient :

$$1 - \dfrac{h_c S\Delta\theta}{P_2}\dfrac{Q_m}{c}\dfrac{1}{Q} + \dfrac{\omega_R^2}{\omega_S^2}\dfrac{1}{Q^2} < 0,$$

fonction de Q qui représente l'influence du circuit à commander à l'aide du transformateur.

Le choix d'un point de fonctionnement Q pour le circuit permet, en utilisant un tel système d'équations, de déterminer les propriétés physiques et géométriques du transformateur. Ce point de fonctionnement peut par exemple être conditionné par des exigences de volume maximal du transformateur, des performances optimales, par exemple en termes de gain, de puissance transmise, de rendement, un compromis entre ces différentes exigences, ou autre. Deux exemples non limitatifs sont donnés ci-dessous.

On souhaite par exemple réaliser un transformateur constitué de deux armatures d'épaisseur $e_1$, $e_2$ et de surface A, et polarisé selon son deuxième mode en vibrations dans l'épaisseur. On choisit d'alimenter le transformateur par une tension d'alimentation $V_1$, à une fréquence d'alimentation $f_R$. Les armatures sont constituées d'un matériau donné, de coefficient de couplage $k_t$, de permittivité $\varepsilon_{33}$, de facteur de qualité mécanique $Q_m$, de densité $\rho$, de module de Young $c_{33}$, de coefficient piézo-électrique $e_{33}$, et de coefficient de convection $h_c$. Le transformateur doit présenter un gain G proche de 1, et fournir une puissance $P_2$ pour un échauffement maximal $\Delta\theta$ à ne pas dépasser.

Les épaisseurs $e_1$ et $e_2$ sont relativement proches dans le cas de deux armatures monocouche, car une couche mince peut difficilement mettre en mouvement une couche épaisse. En conséquence, le gain du transformateur sera proche de 1. Si on souhaite un gain très supérieur à 1, il peut être préférable d'utiliser au secondaire une structure multicouche en parallèle, et d'adapter en conséquence les équations précédentes.

L'épaisseur totale $e_{tot}$ est choisie pour que la fréquence d'alimentation $f_R$ corresponde au deuxième mode de vibration du transformateur qui, dans le cas de deux armatures similaires, permet de minimiser les contraintes au niveau des interfaces de collage et/ou de fixation, pour un gain optimal, comme décrit précédemment. L'épaisseur totale $e_{tot}$ du transformateur peut ainsi être choisie de l'ordre de :

$$e_{tot} = e_1 + e_2 (+ e_3) = 2\pi/\omega_R (c_{33}/\rho)^{1/2}.$$

Pour des matériaux classiquement utilisés pour des armatures primaire et secondaire, par exemple pour le titanate de plomb (M5), le module d'élasticité dans l'épaisseur $c_{33}$ peut par exemple être de l'ordre de 176 GPa, et la densité $\rho$ de l'ordre de 7 400 kg/m$^3$. Pour une vibration à une fréquence de l'ordre de 2,1 MHz, on obtient une épaisseur totale d'environ 2,3 mm ce qui est compatible avec les tailles de circuit imprimé habituellement utilisées pour des transistors de puissance. A des fins d'intégration, l'épaisseur peut être encore réduite en utilisant une fréquence d'excitation du transformateur plus élevée. Néanmoins, un compromis est nécessaire car une augmentation de la fréquence provoque une augmentation des pertes.

Les autres dimensions du transformateur ($A$, $e_1$, $e_2$) sont maintenant déterminées par le choix d'un point de fonctionnement Q du circuit. Deux choix pertinents, mais non exclusifs, sont décrits ci-dessous, mais le dimensionnement du transformateur peut aussi bien être effectué pour tout autre type de point de fonctionnement Q, en particulier dans le cas d'un compromis entre les deux cas décrits ci-après.

Selon un premier exemple, on connaît la puissance $P_2$ à transmettre. Cette puissance comprend la puissance effectivement délivrée au composant de puissance 19, et la puissance éventuellement délivrée aux composants électroniques susceptibles d'être compris entre l'armature secondaire 8 du transformateur 100 et le composant de puissance 19.

On peut trouver deux points de fonctionnement $Q_1$ et $Q_2$ (les deux racines de l'équation de l'échauffement, qui est un polynôme du second degré en Q) entre lesquels l'élévation de température en cours de fonctionnement sera inférieure à la valeur prédéfinie de l'échauffement $\Delta\theta$. Pour ces deux points, l'échauffement du transformateur sera sensiblement égal à $\Delta\theta$ et la puissance délivrée à $P_2$. L'un ou l'autre de ces points peut être retenu.

$$1\!\!\big/Q_{1,2} = \frac{1}{2\,\dfrac{\omega_R^2}{\omega_S^2}}\left\{\frac{2A}{c}\frac{h_c\Delta\theta Q_m}{P_2} \pm \sqrt{\left(\frac{2Ah_c\Delta\theta Q_m}{cP_2}\right)^2 - 4\frac{\omega_R^2}{\omega_S^2}}\right\}.$$

Dans ce premier exemple, on obtient deux dimensionnements possibles du transformateur. On peut alors choisir celui qui semble le plus approprié, par exemple celui qui minimise le volume du transformateur.

Selon un deuxième exemple, on peut vouloir réaliser un transformateur piézo-électrique intégré présentant un rendement donné pour un échauffement et une résistance de charge donnés. On peut par exemple choisir le point de fonctionnement $Q_0$ correspondant au rendement optimal (ce point, correspondant aux pertes minimales, est situé entre $Q_1$ et $Q_2$).

$$Q_0 = \sqrt{1 + 1\!\!\big/2c}.$$

Dans les deux exemples, on peut déterminer la surface $A$ des armatures primaire et secondaire et le rapport $r = e_2/e_1$ des épaisseurs des armatures correspondant audit échauffement $\Delta\theta$, audit point de fonctionnement Q, et à ladite puissance à transmettre, à l'aide notamment de l'expression de G et de $P_2$. On peut par exemple exprimer G et $P_2$ en fonction de $A$ et du rapport $r$, tous les autres paramètres étant connus et le facteur de qualité électrique Q s'exprimant également en fonction de $A$ et de $r$. On résout de façon appropriée ce système, par exemple numériquement ou graphiquement. On retrouve finalement l'épaisseur de chaque armature à partir de $r$ et de $e_{tot}$.

On peut ainsi dimensionner un transformateur piézo-électrique intégré dans un circuit imprimé délivrant une puissance $P_2$ pour un échauffement maximal autorisé $\Delta\theta$. En utilisant les valeurs obtenues pour $A$ et $r$ dans les différentes équations, on peut identifier les différentes valeurs des composants du modèle équivalent, et en particulier les résistances de charge $R_L$ admissibles comprises entre les valeurs $R_{L1}$ et $R_{L2}$ correspondant à $Q_1$ et $Q_2$. On peut en outre prévoir les performances de fonctionnement dudit transformateur, car le rendement de transmission $\eta$, le gain, et la puissance transmise entre autres, sont liés aux caractéristiques du circuit et donc du matériau.

Par exemple, on étudie spécifiquement le cas d'un transformateur piézo-électrique composé de deux armatures primaire et secondaire similaires en titanate de plomb (M5), de coefficient de couplage $k_t = 0{,}5$, de permittivité $\varepsilon_{33} = 179\varepsilon_0$ (où $\varepsilon_0$ est la permittivité du vide), de facteur de qualité mécanique $Q_m = 400$, de coefficient piézo-électrique $\varepsilon_{33} = 8{,}5$, et

de coefficient de convection $h_c$=15 WK$^{-1}$m$^{-2}$, le transformateur étant alimenté à une fréquence $f_R$=2,1 MHz, et transmettant une puissance moyenne de $P_2$=1 W pour un échauffement inférieur à $\Delta\theta$=40°c, à des tensions d'entrée $V_1$ et $V_2$ égales à 15 V (G=1). On souhaite par exemple minimiser le volume de ce transformateur.

En choisissant $Q_1$ comme point de fonctionnement, on obtient une épaisseur totale $e_{tot}$ = 2,3 mm, une surface A = 164,7 mm$^2$ et un rapport r = 0,89 (soit environ $e_1$ = 1,1 mm et $e_2$ - 1,2 mm). Le rendement d'un tel transformateur est $\eta$=0,89 et la puissance dissipée dans le transformateur de 247 mW.

En choisissant $Q_2$ comme point de fonctionnement, la résolution donne un rapport r supérieur à 6, ce qui donnerait des armatures d'épaisseur très différentes.

On peut également obtenir un rendement optimal en choisissant $Q_0$ comme point de fonctionnement. On aurait obtenu une épaisseur totale $e_{tot}$ = 2,3 mm, une superficie A = 1000 mm$^2$, et un rendement d'environ 0,95. Le volume est néanmoins supérieur au volume obtenu pour $Q_1$.

Le matériau constitutif des armatures peut être choisi en mettant en oeuvre ce procédé pour différent types de matériaux disponibles, par exemple sur catalogue, et en sélectionnant celui offrant les caractéristiques les plus appropriées pour l'application souhaitée.

A cause des contraintes liées à la fabrication du transformateur (fabrication en série, ...), on peut bien sûr utiliser un transformateur de dimensions voisines ayant des performances voisines du cas décrit ici. En outre, un tel dimensionnement peut également être réalisé en prenant en compte la couche intermédiaire 6, les propriétés des moyens de fixation des armatures sur le substrat, ou d'autres paramètres négligés ici si, dans l'application souhaitée, ces paramètres s'avéraient importants.

Les armatures ainsi dimensionnées d'un transformateur piézo-électrique sont préparées et intégrées dans le circuit imprimé, comme précédemment décrit.

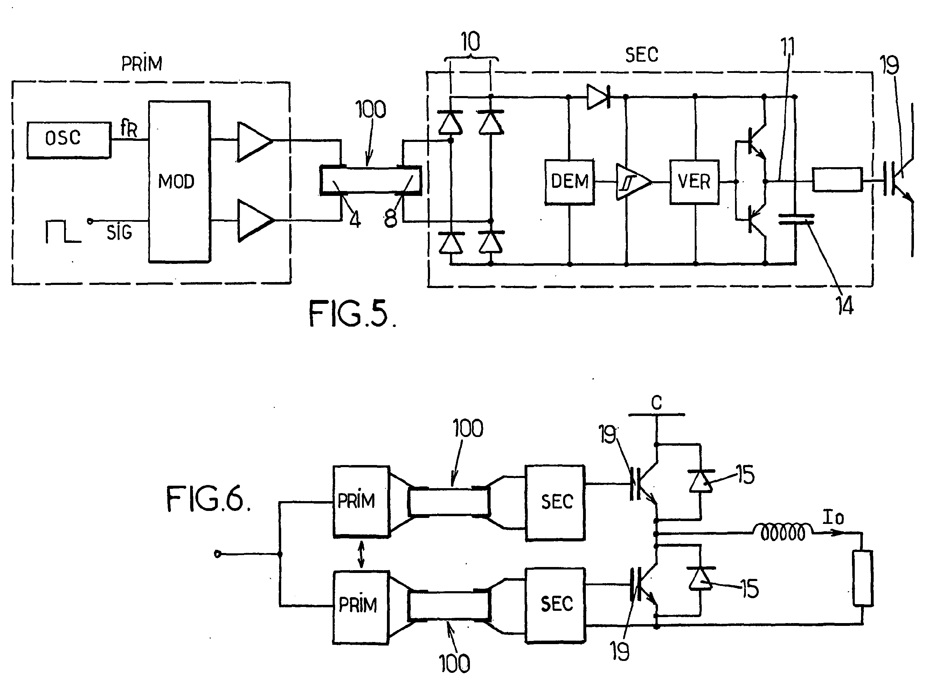

La figure 5 représente schématiquement l'utilisation d'un transformateur piézo-électrique 100 intégré, pour réaliser une commande rapprochée d'un composant électronique 19 tel qu'un composant semi-conducteur de puissance, et en particulier un transistor MOSFET ou IGBT. L'armature primaire 4 est connectée à un circuit primaire PRIM, dont les composants sont par exemple fixés sur la première couche 2 du circuit imprimé (tel le composant électronique 3 de la figure 1). L'armature secondaire 8 est connectée à un circuit secondaire SEC, dont les composants sont par exemple intégrés sur la deuxième couche 5 du circuit imprimé (tel le composant électronique 9 de la figure 1).

Pour avoir un rendement adéquat, le transformateur 100 doit être alimenté par un oscillateur OSC à une fréquence $f_R$, qui peut être par exemple une de ses fréquences de résonance, (en particulier, le deuxième mode de vibration dans l'épaisseur, de l'ordre de quelques MHz par exemple). Cette fréquence n'est généralement pas liée à la fréquence du signal de commande SIC de la grille du transistor amorçant et bloquant le transistor et qui peut être de l'ordre du kHz ou de la dizaine de kHz par exemple.

On peut prévoir un module MOD, par exemple un HEF4013 de la Société Philips ou analogue qui transmet le signal de commande SIC par exemple par une modulation pleine onde à la fréquence de résonance mécanique $f_R$ du transformateur 100, qui peut être choisie très supérieure à la fréquence du signal de commande.

Le signal modulé ainsi transmis au transformateur intégré est récupéré au niveau de l'armature secondaire 8 et doit être démodulé pour permettre la réalisation d'un dispositif de commande rapprochée fiable. En effet, le signal récupéré au niveau de l'armature secondaire 8 est également à la fréquence $f_R$. On peut par exemple redresser ce signal, de manière classique, à l'aide d'un pont de diode 10, et le démoduler à l'aide d'un démodulateur DEM, qui détecte l'enveloppe du signal de sortie.

On peut alternativement réaliser une modulation d'amplitude à deux niveaux, ou encore une modulation à deux fréquences. Dans ce cas, le transformateur piézo-électrique peut être alimenté par un signal alternatif pouvant prendre deux fréquences différentes. La modulation est par exemple obtenue par un multiplexeur piloté par le signal de commande, transmettant l'un ou l'autre de deux signaux de fréquences voisines, émis par des oscillateurs.

Une démodulation appropriée du signal transmis par l'armature secondaire peut par exemple consister en l'utilisation d'une PLL (« phase-locked loop ») fournissant une tension proportionnelle à la fréquence transmise, ou tout autre moyen approprié. Cette alternative permet une variation du rapport cyclique du signal entre 0 et 1. D'autres systèmes de modulation/démodulation sont applicables dans le cadre de l'invention.

A la sortie du démodulateur DEM, lorsqu'un ordre de commutation intervient dans le signal de commande, l'établissement d'une tension de commande d'une amplitude suffisante pour commander le composant électronique de puissance 19 est obtenu par exemple grâce à la capacité 14 qui stocke l'énergie fournie à l'armature secondaire 8.

Il y a un régime transitoire d'environ une dizaine de microsecondes, qui correspond au temps nécessaire à l'établissement d'un régime vibratoire stable dans le transformateur 100. Ce temps de retard $t_R$ est lié aux propriétés du matériau utilisé ($t_R$=2e$^2\rho$/$\eta\Pi$). On peut donc réduire le temps de retard $t_R$ en diminuant l'épaisseur ou en augmentant la viscosité $\eta$, ce qui dans chaque cas accroît les pertes dans le transformateur. Un compromis doit donc être réalisé entre temps de retard et pertes.

Pour s'affranchir des problèmes liés à ce temps de retard, on peut éventuellement prévoir un dispositif de verrouillage VER, par exemple sous la forme d'une bascule logique dont l'état est bloqué sur une durée prédéterminée après chaque ordre de commutation. Ce dispositif de verrouillage permet de fournir au noeud 11 de sortie, une tension redressée avec l'amplitude nécessaire pour la commande du composant électronique de puissance 19, tout en garantissant une grande fiabilité et en particulier une excellente robustesse aux perturbations électromagnétiques.

On peut ainsi fournir avec une excellente isolation galvanique un signal de commande rapprochée à un composant électronique de puissance 19.

La figure 6 représente la réalisation d'un bras de pont complet, utilisant deux transformateurs piézo-électriques 100 tels que précédemment décrits, intégrés dans un circuit imprimé, avec leurs armatures primaire et secondaire également telles que précédemment décrites. On peut par exemple prévoir que l'armature primaire de chaque transformateur soit intégrée sur une première couche 2 de circuit imprimé, et que leur armature secondaire, voire les composants électroniques de puissance 19, soient intégrés sur la deuxième couche 5. Chaque transformateur 100 permet de commuter un composant électronique 19 tel qu'un transistor IGBT (et la diode 15 adaptée) d'un bras de pont complet. Par exemple, ce bras de pont a une puissance de 3 kW (tension U maximale commutée de 300 V pour un courant maximum commuté $I_0$ de 20 A) à 40 kHz, avec un rapport cyclique pouvant varier entre 0 à 1. La structure même de chaque transformateur 100 intégré assure l'isolation galvanique, et assure la robustesse du système vis-à-vis des courants de mode commun, circulant à travers les deux commandes rapprochées, et en particulier les courants liés au couplage capacitif parasite entre les armatures primaire et secondaire des transformateurs 100. Ce couplage peut être élevé car les armatures primaire et secondaire présentent un coefficient de permittivité relativement élevé. Cette permittivité élevée permet néanmoins de réaliser un transformateur 100 présentant un champ de claquage élevé, par exemple de l'ordre de plusieurs kV/mm.

Contrairement aux dispositifs utilisés dans l'art antérieur pour réaliser une commande rapprochée d'un transistor à grille isolée, qui pouvaient nécessiter des composants bobinés non standard, le transformateur utilisé dans le cadre de l'invention est facilement industrialisable.

Il peut de plus être fortement miniaturisé, nécessitant ainsi de faibles coûts de fabrication.

## Revendications

1. Circuit électronique (1) muni d'un transformateur piézo-électrique (100) destiné à commander un composant électronique (19), dans lequel le transformateur (100) comprend une armature primaire (4) et une armature secondaire (8), constituées à partir d'un matériau piézo-électrique, et une couche intermédiaire (6) isolante, intercalée entre les armatures primaire (4) et secondaire (8), l'armature primaire (4) étant agencée pour transmettre, en réponse à un signal primaire transmis à l'armature primaire via le circuit électronique, un signal moteur à l'armature secondaire (8), à travers la couche intermédiaire (6), l'armature secondaire (8) délivrant au composant électronique (19) un signal secondaire, fonction du signal primaire, pour commander le composant électronique (19) auquel l'armature secondaire (8) est connectée,
**caractérisé par le fait qu'**il comporte une première couche (2) dans laquelle est intégrée l'armature primaire (4) et une deuxième couche (5) dans laquelle est intégrée l'armature secondaire (8), les première (2) et deuxième (5) couches étant galvaniquement isolées par la couche intermédiaire (6).

2. Circuit électronique selon la revendication 1, dans lequel les première (2) et deuxième (5) couches sont constituées d'un substrat de matériau choisi parmi du circuit imprimé, de la céramique et du semi-conducteur, et supportent chacune une face de circuit imprimé, les armatures primaire (4) et secondaire (8) étant fixées dans des évidements (13) préalablement ménagés respectivement dans chacune des couches.

3. Circuit électronique selon la revendication 2, dans lequel au moins une couche conductrice (6a) est intercalée entre les première (2) et deuxième (5) couches.

4. Circuit électronique selon l'une des revendications précédentes, dans lequel le composant électronique (19) est un transistor de puissance intégré à la deuxième couche (5) et comportant une grille recevant le signal secondaire.

5. Circuit électronique selon l'une des revendications précédentes, la première couche (2) comportant un circuit primaire (PRIM) comprenant un modulateur (MOD) connecté à l'armature primaire (4), et adapté pour former le signal primaire avec une modulation d'au moins un signal porteur par un signal de commande (SIC), et pour délivrer à l'armature primaire (4) le signal primaire ainsi formé,
et la deuxième couche (5), comportant un circuit secondaire (SEC) comprenant un démodulateur (DEM), connecté entre l'armature secondaire (8) et le composant électronique (19), et adapté pour transmettre à ce composant électronique (19) un signal démodulé à partir du signal secondaire correspondant au signal de commande.

**6.** Circuit électronique selon la revendication 5, dans lequel le circuit secondaire (SEC) comprend en outre un dispositif de redressement (10), connecté entre l'armature secondaire (8) et le démodulateur (DEM), et adapté pour redresser le signal secondaire délivré par l'armature secondaire (8).

**7.** Circuit électronique selon l'une des revendications 5 et 6, dans lequel le circuit secondaire (SEC) comprend en outre un dispositif de verrouillage (VER) connecté entre le démodulateur (DEM) et le composant électronique (19), et adapté pour délivrer au composant électronique (19) un signal démodulé fiabilisé.

**8.** Circuit électronique selon l'une des revendications 5 à 7, comprenant un oscillateur (OSC) adapté pour délivrer au modulateur (MOD) le signal porteur à une fréquence proche d'une fréquence ($f_R$) de résonance mécanique du transformateur (100).

**9.** Circuit électronique selon la revendication 8, dans lequel l'oscillateur (OSC) est adapté pour délivrer un signal porteur à une fréquence proche de la fréquence du deuxième mode propre de vibration du transformateur (100).

**10.** Circuit électronique selon l'une des revendications précédentes, dans lequel les armatures primaire (4) et secondaire (8) sont formées à partir d'un matériau piézo-électrique polarisé selon l'épaisseur.

**11.** Circuit électronique selon l'une des revendications précédentes, dans lequel le composant électronique (9) est un transistor MOSFET ou IGBT.

**12.** Circuit électronique selon l'une des revendications précédentes, comprenant en outre une armature primaire piézo-électrique supplémentaire intégrée à la première couche (2), et une armature secondaire piézo-électrique supplémentaire intégrée à la deuxième couche (5) et reliée à un composant électronique supplémentaire (19), les composants électroniques (19) étant connectés pour réaliser un bras de pont complet.

**Claims**

**1.** An electronic circuit (1) provided with a piezoelectric transformer (100) for driving an electronic component (19), in which circuit the transformer (100) comprises a primary plate (4) and a secondary plate (8) made from a piezoelectric material, together with an intermediate insulating layer (6) interposed between the primary and secondary plates (4, 8), the primary plate (4) being arranged to transmit a displacement signal to the secondary plate (8) through the intermediate layer (6) in response to a primary signal that is transmitted to the primary plate via the electronic circuit, and the secondary plate (8) delivering a secondary signal to the electronic component (19) as a function of the primary signal for the purpose of driving the electronic component (19) to which the secondary plate (8) is connected, the circuit being **characterized by** the fact that it comprises a first layer (2) in which the primary plate (4) is integrated and a second layer in which the secondary plate (8) is integrated, the first and second layers (2, 5) being galvanically isolated from each other by the intermediate layer (6).

**2.** An electronic circuit according to claim 1, in which the first and second layers (2, 5) are constituted by a substrate of a material selected from printed circuit material, ceramic material, and semiconductor material, and each supporting one printed circuit face, the primary and secondary plates (4, 8) being fastened in recesses (13) previously formed in each of the layers respectively.

**3.** An electronic circuit according to claim 2, in which at least one conductive layer (6a) is interposed between the first and second layers (2, 5).

**4.** An electronic circuit according to any preceding claim, in which the electronic component (19) is a power transistor integrated in the second layer (5) and having a gate receiving the secondary signal.

**5.** An electronic circuit according to any preceding claim, the first layer (2) having a primary circuit (PRIM) comprising a modulator (MOD) connected to the primary plate (4) and adapted to form the primary signal with at least one carrier signal being modulated by a drive signal (SIG), and to deliver the primary signal as formed in this way to the primary plate (4); and
the second layer (5) having a secondary circuit (SEC) comprising a demodulator (DEM) connected between the secondary plate (8) and the electronic component (19), and adapted to transmit to said electronic component (19) a signal demodulated from the secondary signal corresponding to the drive signal.

6.  An electronic circuit according to claim 5, in which the secondary circuit (SEC) further comprises a rectifier device (10) connected between the secondary plate (8) and the demodulator (DEM), and adapted to rectify the secondary signal delivered by the secondary plate (8).

7.  An electronic circuit according to claim 5 or claim 6, in which the secondary circuit (SEC) further comprises a locking device (VER) connected between the demodulator (DEM) and the electronic component (19) and adapted to deliver a reliable demodulated signal to the electronic component (19).

8.  An electronic circuit according to any one of claims 5 to 7, comprising an oscillator (OSC) adapted to deliver the carrier signal to the modulator (MOD) at a frequency that is close to a mechanical resonant frequency ($f_R$) of the transformer (100).

9.  An electronic circuit according to claim 8, in which the oscillator (OSC) is adapted to deliver a carrier signal at a frequency close to the frequency of the second resonant mode of vibration of the transformer (100).

10. An electronic circuit according to any preceding claim, in which the primary and secondary plates (4, 8) are made out of a piezoelectric material that is biased in thickness.

11. An electronic circuit according to any preceding claim, in which the electronic component (19) is a MOSFET or an IGBT.

12. An electronic circuit according to any preceding claim, further comprising an additional piezoelectric primary plate integrated in the first layer (2), and an additional piezoelectric secondary plate integrated in the second layer (5) and connected to an additional electronic component (19), the electronic component (19) being connected to form a complete arm of a bridge.


**Patentansprüche**

1.  Elektronischer Schaltkreis (1), der mit einem piezoelektrischen Wandler (100) ausgestattet ist, welcher dazu dient, ein elektronisches Bauelement (19) zu regeln, in welchem Schaltkreis der Wandler (100) einen Primärbelag (4) und einen Sckundärbelag (8) aufweist, die sich aus einem piezoelektrischen Material zusammensetzen, sowie eine isolierende Zwischenschicht (6), die zwischen den Primärbelag (4) und den Sekundärbelag (8) eingeschoben ist, wobei der Primärbelag (4) so angelegt ist, dass er als Antwort auf ein Hauptsignal, das an den Primärbelag über den elektronischen Schaltkreis übermittelt wurde,
    an den Sekundärbelag (8) durch die Zwischenschicht (6) hindurch ein Bewegungssignal übermittelt, wobei der Sekundärbelag (8) an das elektronische Bauelement (19) ein von dem Hauptsignal abhängendes Hilfssignal liefert, um das elektronische Bauelement (19) zu regeln, mit welchem der Sekundärbelag (8) verbunden ist,
    **dadurch gekennzeichnet, dass** er eine erste Schicht (2) umfasst, in welche der Primärbelag (4) eingegliedert ist, sowie eine zweite Schicht (5), in welche der Sekundärbelag (8) eingegliedert ist, wobei die erste Schicht (2) und die zweite Schicht (5) über die Zwischenschicht (6) galvanisch isoliert sind.

2.  Elektronischer Schaltkreis nach Anspruch 1, in welchem sich die erste Schicht (2) und die zweite Schicht (5) aus einem Stoffsubstrat zusammensetzen, das ausgewählt ist aus einer gedruckten Schaltung, Keramik und einem Halbleiter und dass jede Schicht eine Seite mit einer gedruckten Schaltung aufweist, wobei der Primärbelag (4) und der Sekurtdärbelag (8) in Aussparungen (13) befestigt sind, welche zuvor in die jeweiligen Schichten eingelassen worden sind.

3.  Elektronischer Schaltkreis nach Anspruch 2, in welchem mindestens eine leitende Schicht (6a) zwischen die erste Schicht (2) und die zweite Schicht (5) eingeschoben ist.

4.  Elektronischer Schaltkreis nach einem der vorhergehenden Ansprüche, in welchem das elektronische Bauelement (19) ein in die zweite Schicht (5) integrierter Leistungstransistor ist und ein Gitter umfasst, welches das Hilfssignal empfängt.

5.  Elektronischer Schaltkreis nach einem der vorhergehenden Ansprüche, wobei die erste Schicht (2) einen Primärkreis (PRIM) umfasst, der einen mit dem Primärbelag (4) verbundenen Modulator (MOD) enthält, der so konzipiert ist, dass er mit einer Modulation von mindestens einem Trägersignal mit einem Steuersignal (SIC) das Hauptsignal bildet und das so gebildete Hauptsignal (4) an den Primärbelag (4) sendet,
und wobei die zweite Schicht (5) einen Sekundärkreis (SEC) umfasst, der einen zwischen dem Sckundärbelag (8) und dem elektronischen Bauelement (19) angeschlosscnen Demodulator (DEM) enthält, der so konzipiert ist, dass er aus dem Hilfssignal, das dem Steuersignal entspricht, ein demoduliertes Signal an dieses elektronische Bauelement übermittelt.

6. Elektronischer Schaltkreis nach Anspruch 5, in welchem der Sekundärkreis (SEC) außerdem eine zwischen dem Sekundärbelag (8) und dem Demodulator (DEM) angeschlossene Gleichrichtungsvorrichtung (10) enthält, die so konzipiert ist, dass sie das von dem Sekundärbelag (8) gelieferte Hilfssignal gleichrichtet.

7. Elektronischer Schaltkreis nach einem der Ansprüche 5 und 6, in welchem der Sekundärkreis (SEC) außerdem eine zwischen dem Demodulator (DEM) und dem elektronischen Bauelement angeschlossene Randwertschaltung (VER) enthält, die so konzipiert ist, dass sie an das elektronische Bauelement (19) ein zuverlässig gemachtes demoduliertes Signal liefert.

8. Elektronischer Schaltkreis nach einem der Ansprüche 5 bis 7, welcher einen Oszillator (OSC) enthält, der so konzipiert ist, dass er an den Modulator (MOD) das Trägersignal mit einer Frequenz liefert, die in der Nähe einer mechanischen Resonanzfrequenz ($f_R$) des Wandlers (100) liegt.

9. Elektronischer Schaltkreis nach Anspruch 8, in welchem der Oszillator so konzipiert ist, dass er ein Trägersignal mit einer Frequenz liefert, die in der Nähe der Frequenz der zweiten Eigenschwingung der Vibration des Wandlers (100) liegt.

10. Elektronischer Schaltkreis nach einem der vorhergehenden Ansprüche, in welchem der Primärbelag (4) und der Sekundärbelag (8) aus einem piezoelektrischen, nach der Dicke polarisierten Material gebildet sind.

11. Elektronischer Schaltkreis nach einem der vorhergehenden Ansprüche, in welchem das elektronische Bauelement (19) ein MOSFET- oder ein IGBT-Transistor ist.

12. Elektronischer Schaltkreis nach einem der vorhergehenden Ansprüche, der außerdem einen in die erste Schicht (2) integrierten zusätzlichen piezoelektrischen Primärbelag umfasst sowie einen zusätzlichen piezoelektrischen Sekundärbelag, der in die zweite Schicht (5) integriert und mit einem zusätzlichen elektronischen Bauelement (19) verbunden ist, wobei die elektronischen Bauelemente (19) miteinander verbunden sind, um einen vollständigen Brückenzweig zu bilden.

FIG.1.

FIG.2.

FIG.3.

FIG.4.

FIG.5.

FIG.6.